# EUROPEAN PATENT APPLICATION

(11) **EP 4 711 779 A1**
(43) Date of publication of application: **18.03.2026**
(21) Application number: 25150346.2
(22) Date of filing: 06.01.2025
(51) Int. Cl.: G01R 31/317, H03K 19/0175

(54) **LEVEL SHIFTER CIRCUIT**

(30) Priority: 13.09.2024 IN 202441069270
(71) Applicant: NXP B.V., 5656 AG Eindhoven (NL)
(72) Inventor: Sandifort, Quino, 5656AG Eindhoven (NL); Behrendt, Jan Leewe, 5656AG Eindhoven (NL); van der Heiden, Joannes Theodorus, 5656AG Eindhoven (NL); Gayakwad, Pramod, 5656AG Eindhoven (NL)
(74) Representative: Hardingham, Christopher Mark

(57) **Abstract**

A level shifter test circuit, method of testing a level shifter test circuit and a semiconductor chip are provided. The circuit comprises a first level shifter for translating a signal from a first domain to a second domain. The first level shifter configured to receive the signal as an input from the first domain; and output a translated signal which has been translated by the first level shifter for the second domain, wherein the translated signal is split between a first output signal and a first level shifter feedback signal. The circuit further comprises test logic configured to receive the first level shifter feedback signal and test operation of the first level shifter.

## Description

### FIELD

The present disclosure relates to an apparatus and method for a level shifter circuit comprising feedback for testing a performance of the level shifter.

### BACKGROUND

In state-of-the-art system on chip devices (SOCs), multiple power domain crossings can be found. Typically, these occur at the interface between digital synthesised logic and analog macros. The interface is commonly not tested structurally, leaving fault coverage holes in both production test and functional safety (ISO26262) related self-test.

### SUMMARY

According to a first aspect, there is provided a level shifter test circuit. The circuit comprises a first level shifter for translating a signal from a first domain to a second domain. The first level shifter configured to receive the signal as an input from the first domain; and output a translated signal which has been translated by the first level shifter for the second domain, wherein the translated signal is split between a first output signal and a first level shifter feedback signal. The circuit further comprises test logic configured to receive the first level shifter feedback signal and test operation of the first level shifter.

Optionally, the level shifter test circuit further comprising a feedback logic function. Optionally, wherein the feedback logic function comprises an XOR logic gate.

Optionally, the level shifter test circuit further comprising an end gate for protecting the first output signal in a safe state, the end gate comprising: a protective logic gate configured to receive and protect the first output signal in the safe state; and
an end gate feedback logic gate; wherein an output signal from the protective logic gate is split between a protected first output signal and a first end gate feedback signal, wherein the first end gate feedback signal is directed to the end gate feedback logic gate.

Optionally, the level shifter test circuit further comprising: a second level shifter for translating a second signal from the first domain to the second domain, the second level shifter configured to: receive the second signal as input from the first domain; and output a second translated signal which has been translated for the second domain, wherein the second translated signal is split between a second output signal and a second level shifter feedback signal; and wherein the test logic receives the second level shifter feedback signal. Optionally, further comprising a logic gate which concatenates the first level shifter feedback signal with the second level shifter feedback signal.

Optionally, the level shifter test circuit further comprising a second end gate for protecting the second output signal, the second end gate comprising: a second protective logic gate configured to receive and protect the second output signal in the safe state; and a second end gate feedback logic gate; wherein an output from the second protective logic gate is split between a protected second output signal and a second end gate feedback signal directed to the second end gate feedback logic gate; and wherein the second end gate feedback logic gate is configured to receive a first end gate feedback signal from a first end gate and concatenate this with the second end gate feedback signal. Optionally, wherein the end gate(s) are supplied by a clamp signal, wherein the clamp signal enables a safe state when set to a value of zero and disables the safe state when set to a value of one.

Optionally, the level shifter test circuit further comprises a feedback circuit comprising a feedback logic gate for combining feedback signals. Optionally, further comprising a second domain input signal for sending to the first domain; and a multiplexer for disabling the combined feedback circuit if the device is not in a safe state.

Optionally, the level shifter test circuit further comprises a buffer; and one or more electrostatic discharge protectors.

Optionally, the level shifter test circuit further configured to measure a silicon process speed based on the level shifter feedback signal.

Optionally, wherein the test logic is a scannable register.

According to a second aspect, there is provided a method of testing a level shifter circuit. The method comprises providing a first input signal to a first level shifter and translating the first input signal from the first domain to the second domain, wherein an output signal from the first level shifter is split between a first output signal of the second domain and a first level shifter feedback signal for testing operation of the first level shifter; receiving the first level shifter feedback signal at a first test logic; and determining whether the level shifter circuit is working or not based on the output of the test logic.

According to a third aspect there is a semiconductor chip comprising the level shifter circuit according to the first aspect.

### BRIEF DESCRIPTION OF DRAWINGS

A more complete understanding of the subject matter may be derived by referring to the detailed description and claims when considered in conjunction with the following figures, wherein like reference numbers refer to similar elements throughout the figures.
Figure 1 illustrates a schematic diagram of a level shifter comprising a feedback signal according to an embodiment of the disclosure;
Figure 2 illustrates a circuit diagram of a level shifter test circuit according to an embodiment of the disclosure;
Figures 3A to 3C illustrate alternative circuit diagrams of level shifter feedback circuits according to embodiments of the disclosure.

### DETAILED DESCRIPTION

The following detailed description is illustrative in nature and is not intended to limit the embodiments of the subject matter or the application and uses of such embodiments. As used herein, the words "exemplary" and "example" mean "serving as an example, instance, or illustration." Any implementation described herein as exemplary or an example is not necessarily to be construed as preferred or advantageous over other implementations. Furthermore, there is no intention to be bound by any expressed or implied theory presented in the preceding technical field, background, or the following detailed description.

The present disclosure proposes a level-shifter design which incorporates a feedback path. This allows cover of the level-shifting circuit as well as the receiving power domain in structural testing such as production scan test or logic built-in self-test (Logic-BIST). An apparatus is provided that will act as level-shifter between power domains while simultaneously allowing for structural test coverage of the structure during production test and in-field logic test. This helps to reduce field returns while simultaneously improving failure-in-time, FIT, detectability.

Two feedback circuits can be implemented in the proposed design, one directly behind the level-shifter circuit and a second optional feedback circuit for providing coverage if the output signals are safe stated.

The present disclosure helps to improve security and safety applications where unintended or malicious input vectors can be identified using feedback signals collected from various points throughout the circuit. The feedback signals can be used for fault detection, for example by checking the interface signal input vector.

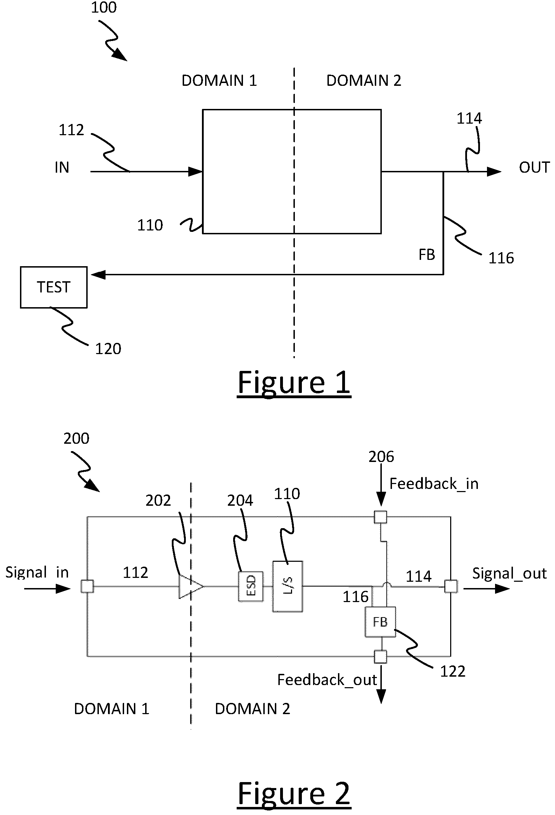

Figure 1 illustrates a schematic diagram of a level shifter test circuit 100 comprising a feedback signal according to an embodiment of the disclosure. The level shifter circuit 110 comprises: a level shifter 110 and test logic 120. The level shifter 110 receives an input signal 112 from a first domain (also called a primary voltage domain) and outputs a translated signal which has been translated for the second domain (also called a secondary voltage domain), wherein the output signal is split between a first output signal 114 of the second domain and a first level shifter feedback signal 116. In one example, the first domain is a low voltage domain and the second domain is a high voltage domain. In an alternative example, the first domain is a high voltage domain and the second domain is a low voltage domain. Other alternatives include wherein the first domain is a low voltage domain and the second domain is a low voltage domain.

A method of testing the level shifter test circuit 100 comprises providing a first input signal 112 to the first level shifter 110 and translating the first input signal 112 from the first domain to the second domain, wherein an output translated signal from the first level shifter 110 is split between a first output signal of the second domain 114 and a first level shifter feedback signal 116 for testing operation of the first level shifter 110. The first level shifter feedback signal 116 is received at a first test logic 120. At the test logic 120, it is determined whether the level shifter circuit is working or not based on the output of the test logic.

The level shifter 110 can be implemented as one of many alternative configurations. For example, where the primary voltage domain is a low voltage domain and the secondary voltage domain is a high voltage domain, the level shifter can be implemented as a latch. When the primary and secondary voltage domains are similar in voltage, the level shifter may be implemented as a buffer. Other alternatives include a buffer type low-to-high level shifter, a buffer type high-to-low level shifter, power and ground level shifter cells, multibit level shifter cells, an overdrive level shifter cell, an enable level shifter cell, and a differential level shifter cell. A latch-based level shifter may be preferred where clamping is desired (clamping is described in more detail below). A multibit level shifter approach can be implemented in embodiments comprising a plurality of level shifter circuits. Using multibit level shifters can help to save space and reduce size of the circuit.

The feedback signal 116 is an input signal to the test logic 120. The test logic 120 is configured to receive the first level shifter feedback signal 116 to test operation of the first level shifter 110. Test logic 120 comprises a component that is suitable for monitoring a current interface state of the signal. In one example, the test logic 120 is a scannable register (e.g. a digital register such as a flip-flop) which allows for live read-back of the feedback signal value. In another example, the test logic 120 is a chip level pin which exposes the signal. In yet another example, the test logic 120 is a logic gate such as an XOR logic gate.

To test the feedback signal 116, a measured signal value measured at the scannable register of the test logic 120 is compared against an expected value. The expected value depends on a given input vector. In some examples, the input vector is tied to a static value (e.g. logic-1 or logic-0). If the feedback signal 116 as received at the test logic 120 does not read a value as expected, it can be determined that a fault (e.g. a defect) is present.

In a scan configuration (logic-BIST or production test/ATPG), the feedback signal 116 is used to derive a pass/fail signature at the test logic 120. In a functional test, the feedback signal 116 is actively read by a controller (e.g. CPU) at the test logic 120 and compared against expected values.

If the testing is at the first domain, the feedback signal 116 needs to be level shifted back to the primary voltage domain for consumption there and fed back to the first domain. If a defect is present in the feedback signal, this will be detected and it is determined that the circuit is not working. If no defects are present, it is determined that the circuit is working as it should.

In digital electronics, a level shifter is a circuit used to translate signals from one logic level or voltage domain to another, allowing compatibility between integrated circuits with different voltage requirements. A level-shifter design including test feedback logic is illustrated in Figure 1. The feedback signal 116 of Figure 1 is behind the level-shift circuit 110 towards the secondary supply domain. It is designed to capture digital cell toggle activity during structural testing, for example during a production scan test or Logic built-in self-test (BIST) in which hardware and/or software is built into integrated circuits allowing them to test their own operation, as opposed to reliance on external automated test equipment.

Soft defects (also called transient defects) and latent defects can be found using the level shifter test circuit 100, where the feedback signal 116 includes these defects. Soft defects are defects that may not be (fully) reproducible. Due to radiation for instance, a logic state in the circuit may change. A soft defect may be a soft error rate, caused for example by the effects of particle impact within sensitive areas of the sub-microelectronic circuit. A latent defect is a defect which was not screened out during production and may develop over a lifetime of the device. Transition or path delay defects can be caused by Bias Temperature Instability (BTI). If there are defects present, the testing logic will detect their presence.

Figure 2 illustrates a circuit diagram of a level shifter test circuit 200 according to an embodiment of the disclosure. The level shifter test circuit 200 of Figure 2 implements the level shifter test circuit 100 of Figure 1 into a standard cell. The level shifter test circuit 200 comprises a buffer 202 in the first domain, and an electrostatic discharge (ESD) protector 204 in the second domain in addition to the level shifter 110 and feedback logic gate 122. The test logic 120 is not illustrated in this example. The buffer 202 replicates a digital signal and increases tolerance to being degraded by other circuitry. The ESD protector 204 protects the transistor from damage against electrostatic discharges during an electrostatic discharge event. The feedback logic gate 122 is used to concatenate signals of level shifters 110 and provides improved efficiency of area coverage. Concatenating signals using logic gates allows for not having to level-shift back to the first domain every single feedback signal output from a level shifter 110, which consumes area on the chip. Suitable logic functions include, but are not limited to, XOR, NAND, NOR, AND, and OR logic gates.

In operation, an input signal 112 (signal_in) is received from domain 1 at the buffer 202. From the output of the buffer 202 at domain 1, the signal is fed to the ESD protector 204 and then to the level shifter 110. An output signal from the level shifter 110 is split into an output signal 114 (signal_out) and a level shifter feedback signal 116.

The level shifter feedback signal 116 is fed into feedback logic function (FB) 122. Feedback logic function 122 comprises but is not limited to one of the following: an XOR, NAND, NOR, AND or OR logic gate. Also fed into the feedback logic function 122 is a second feedback signal 206 feedback in which is a dynamic signal (e.g. a signal which can be toggled). If the level shifter test circuit 200 is a first level shifter test circuit 200, the signal 206 comprises a static logic-0 or logic-1. If the level shifter test circuit 200 is a second level shifter test circuit 200 in a group of circuits, the signal 206 is received from a previous level shifter. The feedback signals 116, 206 received at the feedback logic function 122 are concatenated and output from the feedback logic function 122 as feedback_out. Concatenating multiple level shifters has the advantage of reducing the number of signals that need to be shifted back to primary supply domain, saving space on the chip and reducing the complexity. The output signal from the feedback logic function 122 (level shifter feedback signal), is either fed into the next level shifter in a stack or, at the bottom of a stack, shifted back into the primary voltage domain and consumed by a detecting circuit such as a scannable register.

If the level shifter feedback signal comprises a defect, it is determined that the level shifter circuit comprises a fault. If no defects are present, it is determined that the level shifter circuit does not comprise a fault. The circuit therefore enables structural coverage of the interface in production test, adding ability to detect defects in level shifter circuits.

Providing a level shifter feedback signal in the manner described allows online testing to be performed. This is advantageous because other parts of the chip do not need to be turned off during the testing.

Figure 2 comprises a horizontal cell. Additional cells can be added to the testing circuit 200, above or below the circuit 200. Feedback from additional cells is concatenated between adjacent cells at the feedback logic function 122.

Alternatives to the illustrated circuit in Figure 2 include location of the buffer 202, which could be placed in the first domain, rather than the second domain. In other alternatives, the buffer could be another functional logic placed in the first or second domain. A further ESD protector 204 may also be present in the first domain, for example before the signal reaches the buffer 202.

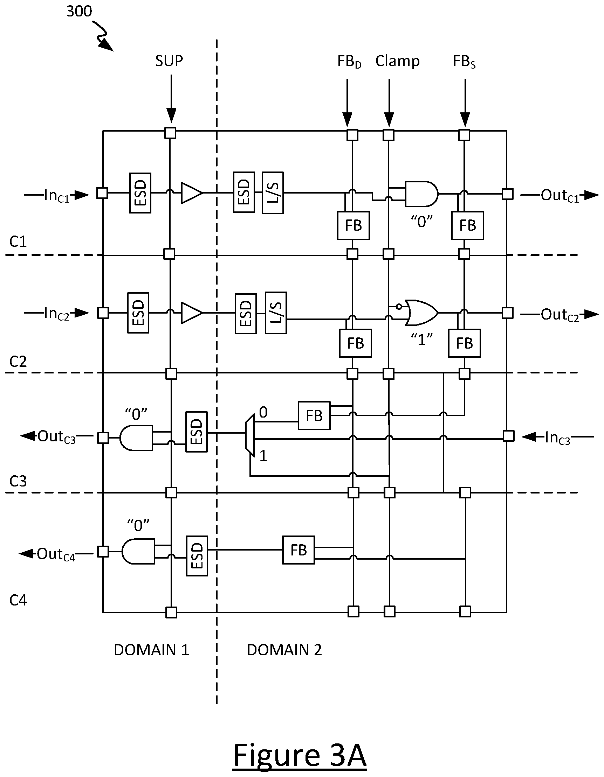

Figure 3A illustrates a circuit diagram of a level shifter test circuit according to an embodiment of the present disclosure. The embodiment illustrated in Figure 3A is an extension of the level shifter test circuits illustrated in Figures 1 and 2.

The circuit comprises horizontal cells C1, C2, C3, C4. Cells C1 and C2 comprise level shifter circuits whilst cells C3 and C4 comprise feedback circuits. In the illustrated embodiment of Figure 3A, feedback logic functions comprising logic gates are all illustrated with the symbol "FB". The type of feedback logic function will depend on its location in the circuit and is interchangeable.

Input signals to the level shifter circuits include input signals In_{C1} and In_{C2} which are input to cells C1 and C2 respectively at the first domain side of the circuit. Output signals Out_{C1} and Out_{C2} are output from cells C1, C2 respectively. Cell C3 receives input signal In_{C3} from the second domain and outputs Out_{C3}. Cell C4 has one output signal only comprising the feedback signal Out_{C4}.

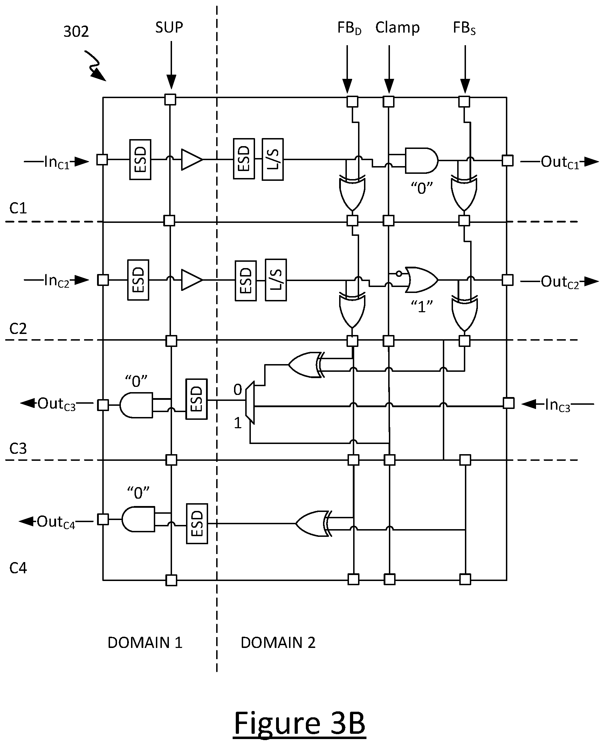

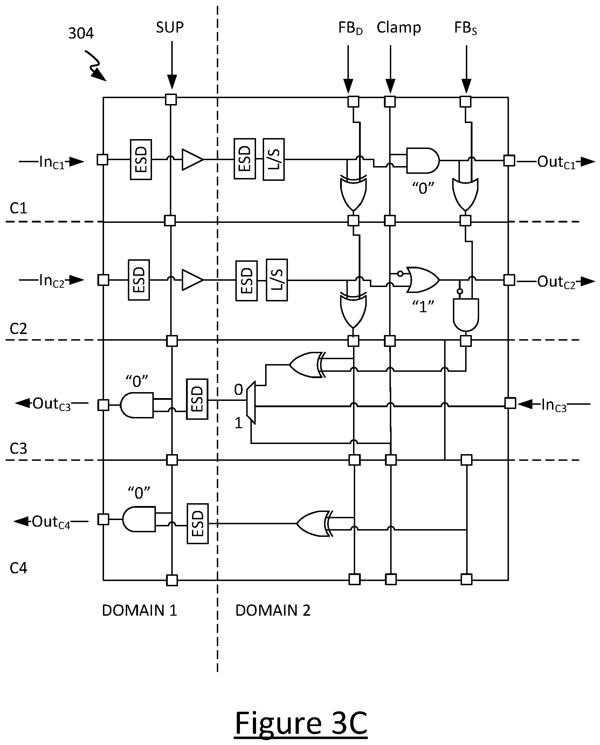

Signals are also applied to the circuit and fed across the cells. These include a supply (SUP) signal, a dynamic feedback signal, FB_{D} (which can be toggled), a clamp signal, and a static feedback signal, FB_{S} (which cannot be toggled). The supply signal acts as a supply presence indicator and can be used, for example, to disable an output (e.g. output signals Outcs and Out_{C4} in Fig 3A, B, C) in the case of loss of supply. The feedback signals FB_{D}, FBₛ can either be a static tie signal, an input from an adjacent level shifter, or another logic signal the behaviour of which is deterministic and known. In the case that the FB_{D}, FBs signals are known, this can be used to determine the resulting signature of output signals Outcs and OutC4 from C3 and C4 respectively. The clamp signal is a control signal to enable or disable the safe-stating function of the level shifter output circuit. The clamp signal enables a safe state when set to a value of zero and disables the safe state when set to a value of one.

First and second cells C1, C2 include level shifter test circuits for translating input signals In_{C1}, In_{C2} respectively from the first domain to the second domain. Translated output signals Out_{C1} and Out_{C2} are output respectively from C1 and C2. The level shifter test circuits of Figure 3A comprise the elements of Figure 2 described above. In addition to the level shifter circuit of Figure 2, an ESD protector is provided at the first domain side of the circuit, before the signal arrives at the buffer. The buffer is located at the first domain in the embodiment illustrated in Figure 3A. The buffer 202 can be placed in domain 1 and/or domain 2. In domain 2 the ESD and the level shifter (L/S) can be blocked together in C1, for example, or ESD and L/S can be placed as individual elements. Many alternative arrangements are possible and considered by the present disclosure.

Cell C1 comprises a first feedback logic function and cell C2 comprises a second feedback logic function. Each of the logic functions are one of an XOR, NAND, NOR, AND or OR logic gate. The first feedback logic function takes as input the feedback signal FB_{D} and the feedback signal from the first level shifter of the first cell C1 (first level shifter feedback signal). The feedback signal FB_{D} comprises a value of logic-0 or logic-1. The second feedback logic function takes as input an output from the first logic function of the first cell C1 comprising a concatenation of the feedback signal FB_{D} and the feedback signal of the first level shifter of C1, and a feedback signal from the second level shifter of the second cell C2 (second level shifter feedback signal).

Also illustrated in Figure 3A at the end of the cells C1, C2 are end gates which are additional features of the circuit to that illustrated in Figure 2. The end gates are used to safe state output signals from the level shifter circuits and protect them from intermittent or illegal signal states. An end gate comprises a protective logic gate configured to receive and protect the output signal from the level shifter in a safe state as required. The protective logic gate receives as input a clamp signal and the output signal from the level shifter. A safe stated output signal Out_{C1}, Out_{C2} is output from the protective logic gates of the first and second cells C1, C2 respectively. The end gate also comprises an end gate feedback logic gate (e.g. logic function). The output signal from the protective logic gate can be split between an output signal of the cell (a protected output signal) and an input signal to the feedback logic gate of the end gate (an end gate feedback signal) which is directed to the end gate feedback logic gate. The feedback logic gate also receives an input signal comprising a static feedback signal FBs which can be used to observe the state of the logic behind the end gate (protection/safe-stating circuit). While it is not possible to arbitrarily toggle this signal, it will still be possible to detect defects, if for instance the protection provided by the safe-state does not work properly. The end gate feedback logic gate outputs an end gate feedback signal for using to determine a performance of the end gate. The end gates therefore provide a second feedback circuit, additional to the first feedback circuit of the level shifters described above in relation to Figures 1 and 2. This secondary feedback circuit provides coverage when the output signals are safe stated. Defects here will cause the secondary feedback circuit to change state compared to an expected state, which makes it possible to identify a defect. Defects detected include Design for Testability (DfT) defects like Bridge, Open, or Stuckat faults etc. If instead of a logic-0, the output of C1 produces a logic-1 (due to a defect), then the secondary feedback circuit will reflect this. Similarly, if instead of a logic-0, the output of C1 follows the input of C1 (due to a defect), then the secondary feedback circuit will reflect this, too. This knowledge is used to detect defects in the end gate circuits.

To safe state the signals a clamp signal is used. The clamp signal is input to protective logic gates at the end gate and the clamp signal can have a value of "logic-0" or "logic-1". When the clamp signal equals logic-0 the signal is protected in a safe state. This safe stated signal is fed back to the primary side. If safe stating is no longer needed, the clamp signal can be set to logic-1 and the output signal of the end gate will follow the input signal of the end gate, i.e. an output signal from the level shifter. The clamp signal affects all of the cells such that if the clamp signal equals logic-0 all of the level shifters in the device are in a safe state (and vice versa).

The end gate of cell C1 comprises a protective logic gate which is an AND gate whilst the end gate of cell C2 comprises a protective logic gate which is an OR gate with one of the signals inverted. The "0" of the C1 logic gate and "1" of the C2 logic gate represent the desired safe values which are expected at the output of C1 and C2 (Out_{C1}, Out_{C2}) once the clamp signal is active (i.e. clamp signal has a value of 0).

The first end gate feedback logic gate (of cell C1) comprises function logic that receives as input, feedback signal FB_{S} and the first end gate feedback signal (from an output of the protective logic gate of cell C1). These signals can be concatenated and output from the first end gate feedback logic gate of cell C1. The second end gate feedback logic gate (of cell C2) comprises function logic that receives as input the second end gate feedback signal (from an output of the second protective logic gate of cell C2) and the output from the first end gate feedback logic gate of cell C1. The concatenated output signal from the second end gate feedback logic gate comprises FBs, the first end gate feedback signal (of cell C1), and the second end gate feedback signal (of cell C2).

Any number of cells similar to cells C1, C2 comprising level shifted test circuits may be added above and/or below cells C1 and C2. The feedback signals from each additional cell can be concatenated in the same way as described above. However, considerations should be made to a number of cells which will affect the timing arc of the circuit which is dependent on the number of level shifters and end gates present in the test circuit. The timing arc comprises the amount of time it takes a signal that is input at cell C1 to be output at cell C4, for example. More cells will increase the duration of the timing arc whilst fewer cells will reduce the duration of the timing arc.

Cell C3 comprises a first feedback cell. A signal In_{C3} is input from the second domain to be sent to the first domain. Feedback from the level shifter circuits and from the end gates of C1 and C2 is combined, for example concatenated, at feedback logic function FB in cell C3. An output from the feedback logic gate comprises all the feedback signals in one.

A multiplexer is also used in this cell. The multiplexer receives: a signal comprising the concatenated feedback from the feedback logic function FB, an input signal from the second domain, and the clamp signal. If the clamp signal is logic-0 (end gates in safe state), Cell C3 acts as a feedback cell, providing the concatenated feedback signals received from cells C1 and C2 for testing. If the clamp signal is logic-1 (no safe stating), C3 acts as a regular level shifter from domain 2 to domain 1 and no feedback signal is provided in the output signal Outca.

After passing the multiplexer, the signal goes through an ESD protector and an AND gate and is output as signal Outcs. The level shifting function for delivering the signal from the second domain back to the first domain may be achieved by the electric properties of the AND gate in domain 1 of cell C3 (and cell C4 described below). This can depend on the primary and secondary domain voltages among other things. In other embodiments, an alternative is to further include a latch in the feedback circuit. Implementations are determined by the voltages of the individual circuits.

If defects are present in the feedback signal, these will be present in the output signal Out_{C3} and can be detected by test logic such as a scannable register as described above. In production test, a deviation from the expected signature will result in a fail result of the test and the defective device can be screened out. In safety applications, deviation from an expected result can be escalated to a safety monitor and the switch may be moved to a safe state. For failure analysis, the signal may be evaluated against different input vectors to pinpoint the location of the defect. For example, cells can be tested individually to determine where the faulty part of the circuit is.

Cell C4 is also a feedback cell like C3. However, cell C4 does not comprise an input signal from the second domain. A feedback logic gate is used to combine (e.g. concatenate) the feedback signals from the level shifter and end gates of cells C1, C2 to be output as output signal Out_{C4}. The signal passes through an ESD combiner and an AND gate, similar to cell C3.

If the feedback signal Out_{C4} output from cell C4 comprises defects, these can be detected in a similar manner to cell C3.

Silicon process speed can be calculated based on level shifter feedback signals using the concatenated chain of level shifter feedback paths, concatenated at the logic gates in the signal path and output in signals Out_{C3}, Out_{C4}. The timing arc absolute duration (from the first level shifter all the way to where the feedback is collected) can be measured using on-chip instruments. This duration is process-, temperature-, and voltage-dependent and can be used for characterisation. From the silicon process speed, the duration being a measure of voltage, the present disclosure can also be used as a temper detector to detect if the voltage has been tampered with (for security applications).

The horizontal slices C1, C2, C3, C4 are standard cells that are delivered against sign-off criteria in all corners relevant for functional operation as well as test operations. This includes screening corners such as very-low-voltage, VLV, and high-voltage-stress-test, HVST, under which conditions the level shifters must be guaranteed to be fully operational.

Combinations of different cells are possible beyond what is illustrated in Figure 3A. For example, only one of cells C3, C4 may be present or further cells C1, C2 may be present.

Cells C1, C2 as illustrated in Figure 3A comprise the same components, however, in some cases the components may differ between the cells.

Specific implementations of Figure 3A are dependent on a technology library, where different types of gates may be more or area- and timing- efficient. Many implementations are possible, and can be optimized based on area, speed, or other factors. Figure 3B illustrates the circuit of Figure 3A in an implementation where all the logic gates of the circuit comprise XOR gates.

Figure 3C illustrates the circuit of Figure 3A in an implementation where the level shifter feedback logic gates of C1 and C2 and the logic gates of the feedback cells C3 and C4 comprise XOR logic gates, but where the end gate feedback logic gates comprise an OR gate in cell C1 and an AND gate with one input inverted in cell C2. XOR gates are, in general, larger than AND, NAND, OR and NOR gates and so Figure 3C may be particularly beneficial where space needs to be optimised. The secondary feedback having a fixed and known output value in safe state (which is static and cannot be toggled) makes this particular configuration possible.

Many configurations varying from those illustrated in Figures 3B and 3C are possible using different types of logic gates. Dependent on the technology library, some gates are more area- and timing-efficient than others. Different implementations are possible, and are subject to optimisation against area, speed, amongst other factors. All such configurations are considered herein.

The device illustrated in any of the above figures is present on a semiconductor chip and used in production scan tests or Logic-BIST.

It will be readily understood that the components of the embodiments as generally described herein and illustrated in the appended figures could be arranged and designed in a wide variety of different configurations. Thus, the detailed description of various embodiments, as represented in the figures, is not intended to limit the scope of the present disclosure but is merely representative of various embodiments. While the various aspects of the embodiments are presented in drawings, the drawings are not necessarily drawn to scale unless specifically indicated.

The present invention may be embodied in other specific forms without departing from its essential characteristics. The described embodiments are to be considered in all respects only as illustrative and not restrictive. The scope of the invention is, therefore, indicated by the appended claims rather than by this detailed description. All changes which come within the meaning and range of equivalency of the claims are to be embraced within their scope.

Reference throughout this specification to features, advantages, or similar language does not imply that all of the features and advantages that may be realized with the present invention should be or are in any single embodiment of the invention. Rather, language referring to the features and advantages is understood to mean that a specific feature, advantage, or characteristic described in connection with an embodiment is included in at least one embodiment of the present invention. Thus, discussions of the features and advantages, and similar language, throughout this specification may, but do not necessarily, refer to the same embodiment.

Furthermore, the described features, advantages, and characteristics of the invention may be combined in any suitable manner in one or more embodiments. One skilled in the relevant art will recognize, in light of the description herein, that the invention can be practiced without one or more of the specific features or advantages of a particular embodiment. In other instances, additional features and advantages may be recognized in certain embodiments that may not be present in all embodiments of the invention.

## Claims

1. A level shifter test circuit comprising:
a first level shifter for translating a signal from a first domain to a second domain, the first level shifter configured to:
receive the signal as an input from the first domain; and
output a translated signal which has been translated by the first level shifter for the second domain, wherein the translated signal is split between a first output signal and a first level shifter feedback signal; and
test logic configured to receive the first level shifter feedback signal and test operation of the first level shifter.

2. The level shifter test circuit of claim 1, further comprising a feedback logic function.

3. The level shifter test circuit of claim 2, wherein the feedback logic function is an XOR logic gate.

4. The level shifter test circuit of any preceding claim, further comprising an end gate for protecting the first output signal in a safe state, the end gate comprising:
a protective logic gate configured to receive and protect the first output signal in the safe state; and
an end gate feedback logic gate;
wherein an output signal from the protective logic gate is split between a protected first output signal and a first end gate feedback signal; and
wherein the first end gate feedback signal is directed to the end gate feedback logic gate.

5. The level shifter test circuit of any preceding claim, further comprising:
a second level shifter for translating a second signal from the first domain to the second domain, the second level shifter configured to:
receive the second signal as input from the first domain; and
output a second translated signal which has been translated for the second domain, wherein the second translated signal is split between a second output signal and a second level shifter feedback signal; and
wherein the test logic is configured to receive the second level shifter feedback signal.

6. The level shifter test circuit of claim 5, further comprising a logic gate which concatenates the first level shifter feedback signal with the second level shifter feedback signal.

7. The level shifter test circuit of claim 5 or claim 6, further comprising a second end gate for protecting the second output signal, the second end gate comprising:
a second protective logic gate configured to receive and protect the second output signal in a safe state; and
a second end gate feedback logic gate;
wherein an output from the second protective logic gate is split between a protected second output signal and a second end gate feedback signal directed to the second end gate feedback logic gate; and
wherein the second end gate feedback logic gate is configured to receive the second end gate feedback signal.

8. The level shifter test circuit of any of claims 4 to 7, wherein the end gate(s) is supplied by a clamp signal, wherein the clamp signal enables a safe state when set to a value of zero and disables the safe state when set to a value of one.

9. The level shifter test circuit of any preceding claim, further comprising a feedback circuit comprising a feedback logic gate for combining feedback signal(s).

10. The level shifter test circuit of claim 9, wherein the feedback circuit further comprises:
a second domain input signal for sending to the first domain; and
a multiplexer for disabling the feedback circuit if the level shifter test circuit is not in a safe state.

11. The level shifter test circuit of any preceding claim, further comprising:
a buffer; and
one or more electrostatic discharge protectors.

12. The level shifter test circuit of any preceding claim, further configured to measure a silicon process speed based on the level shifter feedback signal(s).

13. The level shifter test circuit of any preceding claim, wherein the test logic is a scannable register.

14. A method of testing a level shifter circuit, the method comprising:
providing a first input signal to a first level shifter and translating the first input signal from a first domain to a second domain, wherein an output translated signal from the first level shifter is split between a first output signal of the second domain and a first level shifter feedback signal for testing operation of the first level shifter;
receiving the first level shifter feedback signal at a first test logic; and
determining whether the level shifter circuit is working or not based on the output of the test logic.

15. A semiconductor chip comprising the level shifter circuit according to any of claims 1 to 13.
